# EUROPEAN PATENT SPECIFICATION

(11) **EP 3 115 836 B1**
(45) Date of publication and mention of the grant of the patent: **27.09.2017**
(21) Application number: 16153314.6
(22) Date of filing: 29.01.2016
(51) Int. Cl.: G02F 1/1333

(54) **CURVED DISPLAY DEVICE**
GEBOGENE ANZEIGEVORRICHTUNG
DISPOSITIF D'AFFICHAGE INCURVÉ

(30) Priority: 06.07.2015 KR 20150095676
(43) Date of publication of application: 11.01.2017
(73) Proprietor: Samsung Electronics Co., Ltd., Gyeonggi-do 16677 (KR)
(72) Inventor: LEE, Eun-Jae, Seoul (KR); BAI, Young Jai, Gyeonggi-do (KR); AHN, Joon Seok, Gyeonggi-do (KR); LEE, Kyung-Hwan, Gyeonggi-do (KR); YOO, Jun-Mo, Gyeonggi-do (KR); YUN, Sang-Un, Seoul (KR)
(74) Representative: Walaski, Jan Filip

(56) References cited:
- EP-A1- 1 830 336
- EP-A1- 3 076 071
- DE-U1-202013 100 638
- US-A1- 2010 073 620

## Description

The disclosure relates generally to curved display devices, and for example, to a curved display device with a wide aspect ratio screen.

Screens of recent display devices for displaying content are becoming higher in resolution and larger in size. In addition, the display devices are getting thinner and lighter in weight.

Screens of the larger display devices have various aspect ratios including 4:3, 16:9, 16:10, 21:9, etc. As for high resolution content (e.g., 3480x2160 pixels), it may be content of 16: 9 aspect ratio. If the content of 16:9 aspect ratio is to be displayed on a display device of 21:9 or 16:10 aspect ratio, the display device may output the content on the screen by performing 21:9 or 16:10 scaling on the content.

In the case of 21:9 or 16:10 scaling on the content of the 16:9 aspect ratio, distortion of the content may occur on edges of the screen of the display device.

DE202013100638U1 relates to a curved display apparatus, on which the preamble of claim 1 is based. EP1830336A1 relates to a flexible image-displaying device. US2010/073620A1 relates to an image display.

In accordance with an aspect of the present invention, there is provided a curved display device according to claim 1.

Other aspects, advantages, and salient features of the disclosure will become apparent to those skilled in the art from the following detailed description, which, taken in conjunction with the annexed drawings, discloses example embodiments of the disclosure.
FIG. 1A is a schematic front perspective view illustrating an example curved display device;
FIG. 1B is a schematic rear perspective view illustrating an example curved display device;
FIG. 2 is a schematic exploded view illustrating an example curved display device;
FIG. 3 is a schematic plane view illustrating an example curved display device;
FIG. 4 is a schematic front perspective view illustrating an example bottom chassis having a pattern of a curved display device;
FIGs. 5A and 5B are cross-sectional views illustrating example patterns of a curved display device;
FIGs. 6A and 6B are cross-sectional views illustrating example patterns of a curved display device;
FIGs. 7A and 7B are cross-sectional views illustrating example patterns of a curved display device;
FIGs. 8A and 8B are cross-sectional views illustrating example patterns of a curved display device;
FIGS. 9A and 9B are front views illustrating example patterns of a curved display device;
FIG. 10 is a schematic plane view illustrating an example curved display device;
FIGS. 11A and 11B are front views illustrating example patterns of a curved display device;
FIG. 12 is a schematic plane view illustrating an example curved display device;
FIGS. 13A and 13B are front views illustrating example patterns of a curved display device;
FIGs. 14A-14J are cross-sectional views illustrating example patterns of a curved display device;
FIGs. 15A and 15B illustrate an example process of manufacturing a bottom chassis of a curved display device; and
FIGs. 16A, 16B and 16C illustrate an example process of manufacturing a bottom chassis of a curved display device.

Throughout the drawings, like reference numerals will be understood to refer to like parts, components, and structures.

The disclosure will now be described more fully with reference to the accompanying drawings, in which example embodiments of the disclosure are illustrated.

Methods for manufacturing and using the examples of the disclosure will also be described in greater detail below with reference to the accompanying drawings.

In examples of the disclosure, "having higher curvature" or "having greater curvature" may denote or refer to something that is "bent a lot", i.e. is more curved or more tightly curved. For example, in the case of comparing curves (or curved planes) having curvatures of 1000R and 5000R, respectively, the curve having the curvature of 1000R may be said to have "higher curvature" or a"greater curvature". Disclosing that a first curvature is higher than a second curvature, denotes that an element with the first curvature is bent more than an element with the second curvature.

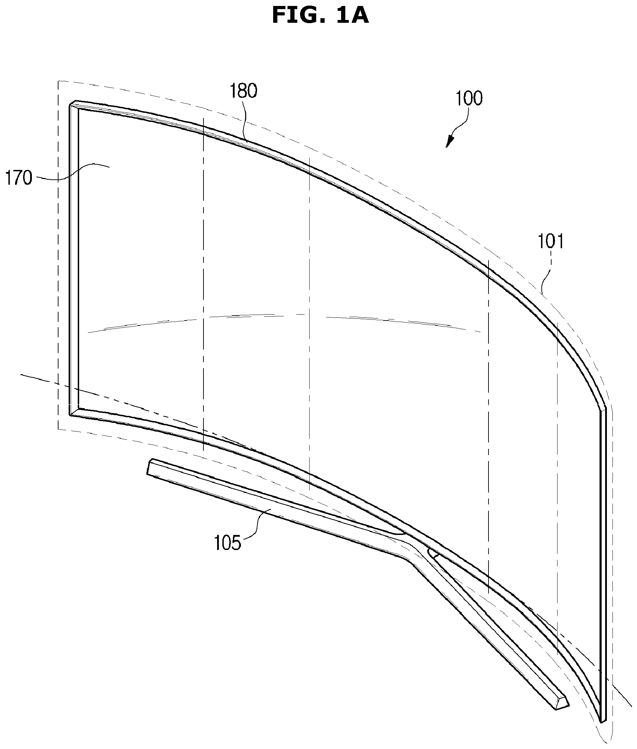

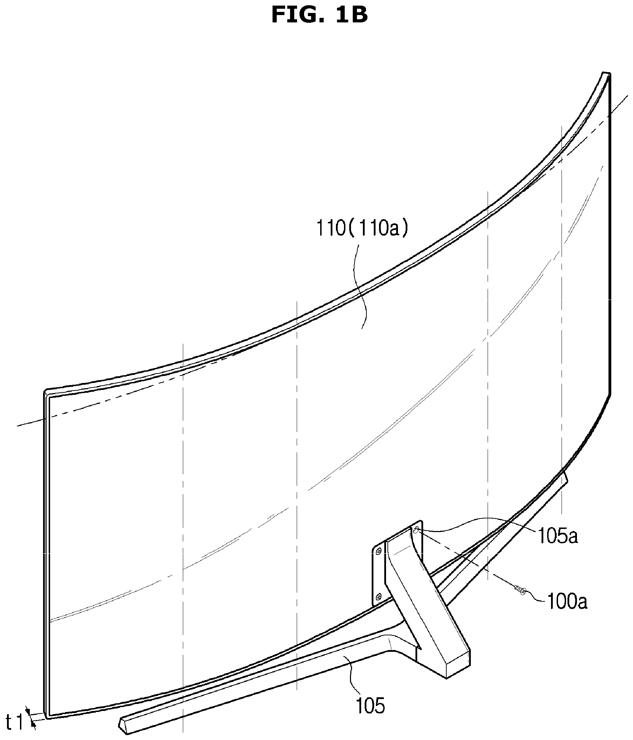

Referring to FIGS. 1A and 1B, a curved display device 100 may, for example, include a curved display unit 101 and a stand 105 supporting the curved display unit 101.

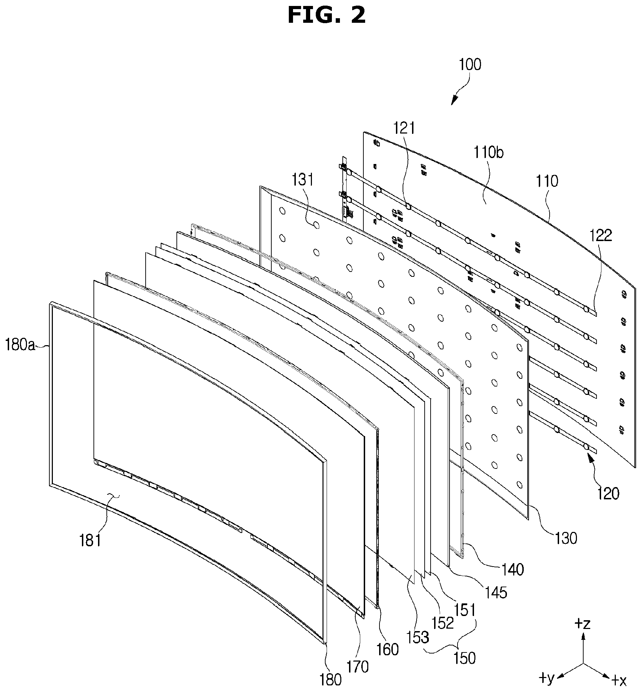

The curved display device 100 may also include a display panel 170 for displaying contents, a bottom chassis 110 and top chassis 180 for supporting the display panel 170. There may be a middle frame 160 as illustrated in FIG. 2 to support the display panel 170. In addition to the aforementioned components, the curved display device 100 may include other various components including e.g., a light source 120 of FIG. 2, a reflecting sheet 130 of FIG. 2, a supporter (not shown), a diffusion plate 145 of FIG. 2, a middle holder 140, and/or the like.

It will be apparent to the skilled people in this art that the size and/or shape of each component of the display device 100 may vary as the display device 100 is slimmed down.

The curved display device 100 may, for example, be an analog television (TV), a digital TV, three dimensional (3D) TV, a smart TV, a light emitting diode (LED) TV, an organic LED (OLED) TV, a plasma TV, a quantum dot TV, and/or a monitor, or the like. Furthermore, the curved display device 100 may, for example, be a mobile phone, a smart phone, an MP3 player, a video player, a tablet personal computer (tablet PC), an electronic board, and/or a wearable device that may be worn by a body part, or the like.

The curved display device 100 may be implemented as a curved display device having a fixed curvature screen, a curved display device having a screen with a plurality of curvatures, e.g., first and second curvatures, a flexible display device having a screen with a plurality of curvatures, and/or a curvature-variable display device that is able to change the current screen curvature based on a received input, but is not limited thereto.

In an example of the disclosure, the curved display device 100 may have a 21:9 aspect ratio, or a cinemascopic aspect ratio (2.35:1), or the like.

Referring to FIG. 1B, the stand 105 may be combined on the rear face 110a of the display device 100 (e.g., with the bottom chassis 110 of the display unit 101). The bottom chassis 110 and the stand 105 may be combined by fastener members 100a, e.g., screws, rivets, and nuts. The fastener members 100a may combine the bottom chassis 110 with the stand 105 by means of fastening holes 105a of the stand 105 and fastening holes (not shown) of the bottom chassis 110.

A power cable (not shown) may be connected to a power terminal (not shown) of the bottom chassis 110 of the display device 100.

Thickness of the display device 100 may, for example, be equal to the thickness t1 of the display unit 101 exclusive of the stand 105. The thickness of the display device 100 may be equal to the uniform thickness t1 of the display unit 101. The thickness t1 of the display unit 101 may be a combined thickness of the bottom chassis 110 and top chassis 180 exclusive of the stand 105. For example, the thickness t1 of the display device 100 may be about 5.4mm or less. The thickness t1 of the display device 100 may be greater than about 4.0mm but less than about 10.0mm. The thickness t1 of the display device 100 may be greater than about 5-0mm but less than about 20.omm.

It will be apparent to the skilled people in this art that the thickness t1 of the display unit 101 may vary as the display device 100 is slimmed down.

The rear face of the display device 100 may be a curved plane if the display device 100 is a curved display device. The curvature of the rear face of the bottom chassis 110 may or may not be equal to the curvature of the display panel 170 of the display device 100.

The curvature of the rear face of the display device 100 and the curvature of the display panel 170 may be different from each other. For example, the curvature of the display panel 170 may be equal to or higher (e.g., greater) than the curvature of the rear face of the display device 100 (e.g., the curvature of the display panel 170 is 2000R while the curvature of the rear face of the display device 100 is 3000R). Alternatively, the curvature of the display panel 170 may be less than the curvature of the rear face of the display device 100 (e.g., the curvature of the display panel 170 is 3000R while the curvature of the rear face of the display device 100 is 2000R).

Four or more Video Electronics Standards Association (VESA) holes or VESA mount holes (not shown) may be formed on the rear face of the display device 100 according to the VESA standard. Alternatively, there may be four or more holes formed on the rear face of the display device 100 according to a non-VESA standard.

A wall mount unit (not shown) may be fastened to the display device 100 by being combined with the VESA holes by means of fastener members (e.g., screws, rivets, etc.)

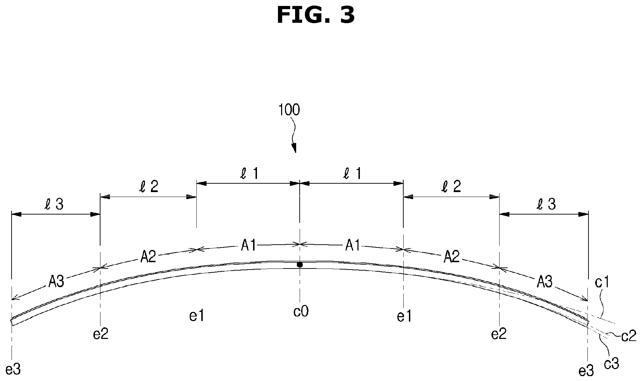

FIG. 2 is a schematic exploded view illustrating an example curved display device. Referring to FIGS. 2 and 3, the curved display device 100 may include the bottom (rear) chassis 110, the light source 120, the reflecting sheet 130, the middle holder 140, the diffusion plate 145, the optical sheet 150, the middle frame 160, the display panel 170, and the top (front) chassis 180. Furthermore, the curved display device 100 may have a curvature corresponding to the curvature of at least one of the bottom chassis 110, light source 120, reflecting sheet 130, middle holder 140, diffusion plate 145, optical sheet 150, middle frame 160, display panel 170, and top chassis 180.

The light source 120, reflecting sheet 130, diffusion plate 145, and optical sheet 150 may collectively be referred to as a direct type backlight unit. Alternatively, components except for the bottom chassis 110, middle holder 140, middle frame 160, display panel 170, top chassis 180, and print circuit board (PCB, not shown) may be referred to as a direct type backlight unit.

The floor (e.g., the rear face 110b) of the bottom chassis 110 may accommodate not only the light source 120 but also the other components (e.g., the reflecting sheet 130, middle holder 140, diffusion plate 145, optical sheet 150, middle frame 160, etc.)

The bottom chassis 110 may be formed as a polygonal plate with high solidity, and may include a metal substance (e.g., aluminum, aluminum alloy, etc.) having low thermal deformation.

The metal substance may, for example, include light metals having a specific gravity of 4 or less, e.g., magnesium, beryllium, titanium, alkali metals, or alkali earth metals. The metal substance may also include nonferrous metals except for iron and ferroalloy.

The bottom chassis 110 may be molded from plastics (e.g., poly carbonate PC). Alternatively, the bottom chassis 110 may be molded by adding glass fiber to a plastic substance.

The light source 120 is part of the direct type backlight unit and thus contained on the floor of the bottom chassis 110 for irradiating light by power supplied from the outside. The light source 120 irradiates light toward the display panel 170 located ahead of the light source 120 (e.g., in +y direction) and serve as backlights for the display device 100. The light source 120 may include LEDs 121. Alternatively, the light source 120 may be a cold cathode fluorescent lamp (CCFL, not shown), or the like. In an example, the light source 120 may include a lens (not shown).

The light source 120 may include multiple LED bars 122 each including multiple LEDs 121. The LED bars 122 may, for example, be arranged apart and in parallel with each other in the bottom chassis 110 on the floor.

The multiple LED bars 122 may be electrically coupled with one another.

The reflecting sheet 130 may have the light irradiated from the light source 120 be incident on the diffusion plate 145, or have the light reflected from the diffusion plate 145 be incident back on the diffusion plate 145. The reflecting sheet 130 may be located above the light source 120 for reflecting light leakage toward the display panel 170, thereby improving optical efficiency.

The reflecting sheet 130 may be coated with high reflective white or silver-colored coating agents, e.g., silver, TiO2. The reflecting sheet 130 may have multiple openings 131 corresponding to multiple projections of the light source 120 accommodated in the bottom chassis 110. The multiple projections of the light source 120 out of the openings 131 of the reflecting sheet 130 may irradiate light onto the diffusion plate 145.

There may be one or more reflecting sheets 130.

A supporter (not shown) may be located on the reflecting sheet 130 for supporting the diffusion plate 145 and/or the optical sheet 150.

The supporter may, for example, be formed of a transparent or opaque material, taking into account an efficiency of the light irradiated from the light source 120.

The supporter may be formed of polyethylene terephthalate glycol, polyethylene, polystyrene, polypropylene, polystyrene paper, acrylonitrile butadiene styrene (ABS), or polycarbonate.

The middle holder 140 may support the diffusion plate 145 and/or the optical sheet 150 by means of multiple middle holder projections (not shown). The middle holder 140 may be accommodated on multiple edges, e.g., four or less edges of the bottom chassis 110. Light irradiated from the light source 120 may be incident upon the diffusion plate 145 and/or the optical sheet 150 without interference of the middle holder 140.

The middle holder 140 may support the reflecting sheet 130 that extends from the light source 120.

The diffusion plate 145 may substantially uniformly diffuse the light irradiated from the light source 120 located below the diffusion plate 145. The middle holder 145 may also support the optical sheet 150 located above the diffusion plate 145. The diffusion plate 145 may uniformly diffuse the light incident from the light source 120 to be output onto the optical sheet 150. The diffusion plate 145 may be made from a transparent or opaque material. The diffusion plate 145 may include acrylic material, urethane material, epoxy material, polyester material, polyamide material, polystyrene material, or polycarbonate material.

The optical sheet 150 may enable the light irradiated from the light source 120 and passing the diffusion plate 145 to have a substantially uniform brightness. The light of substantially uniform brightness that passed the optical sheet 150 is incident upon the display panel 170.

The optical sheet 150 may include multiple sheets 151 to 153 overlaid onto one another by means of the middle holder projections. The multiple sheets 151 to 153 may, for example, include optical sheet projections (not shown) corresponding to the middle holder projections. The optical sheet 150 may include a protective sheet, a prism sheet, a diffusion sheet, or the like. The optical sheet 150 may include not only three but also two or four or more or less sheets.

The middle frame 160 may be located below the display panel 170 for supporting the display panel 170. Furthermore, the middle frame 160 may serve to separate the display panel 170 located above the middle frame 160 from the optical sheet 150 located below the middle frame 160.

The middle frame 160 may include middle frame projections (not shown) to support the optical sheet 150. The middle frame 160 may support the optical sheet 150 by means of the middle frame projections together with the middle holder projections of the middle holder 140.

The middle frame 160 may be formed of ABS resins and/or glass fiber. Alternatively, the middle frame 160 may be formed of various plastics, resins, and/or metals.

For example, the display panel 170 may include a Thin Film Transistor (TFT) substrate and a liquid crystal display (LCD). In another example, the display panel 170 may include a TFT substrate and Active Matrix Organic Light Emitting Diodes (AMOLEDs). In yet another example, the display panel 170 may include a TFT substrate and OLEDs. It should be noted that the display panel 170 is not limited thereto.

The display panel 170 may include a polarizer (not shown) and/or a color filter (not shown).

For example, a printed circuit board (PCB, not shown) for producing signals to drive the display panel 170 may be located in the lower part of the display panel 170. In another example, the PCB for producing signals to drive the display panel 170 may be located in the upper part of the display panel 170. In yet another example, the PCB for producing signals to drive the display panel 170 may be located on either or both of the left and right sides of the display panel 170.

The display panel 170 and the PCB may be electrically coupled through a Chip On Film (COF, not shown). For example, the COF may electrically connect the display panel 170 supported inside the bottom chassis 110 to the PCB located outside the bottom chassis 110. Part of the COF and the PCB located outside the bottom chassis 110 may not be exposed due to a rear cover (not shown).

In another example, the COF may electrically connect the display panel 170 supported inside the bottom chassis 110 to the PCB located inside the bottom chassis 110.

In yet another example, the display panel 170, the COF, and the PCB may be connected to one another in the direction of gravity (e.g., in -z direction). The middle frame 160 may be located below the display panel 170.

The top chassis 180 may be combined with the bottom chassis 110 that accommodates the components 120 to 170 of the display unit 101. The top chassis 180 may be arranged on the front of the curved display device 100 for protecting the components 120 to 170 accommodated therein against external shocks and/or leakage of light (loss of light) irradiated from the internal light source 120.

The top chassis 180 may be formed along the edges of the display panel 170. The top chassis 180 may have a cross-sectional form that may cover the top and side edges of the display panel 170, e.g., the form of " 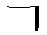 ". The top chassis 180 may include an opening 181. A front face 180a of the four edges of the top chassis 180 exclusive of the opening 181 may be referred to as a "bezel".

Contents output from the display panel 170 may be presented through the opening 181. An active area (not shown) of the display panel 170 and part of a black matrix area (not shown) (e.g., area of about 3mm or less from the edges of the bezel bordered with the opening) may be presented through the opening 181. In another example, the part of the black matrix area (e.g., an area of about 10mm or less from the edges of the bezel bordered with the opening) may be presented through the opening 181.

The narrower the width of the bezel 180a of the top chassis 180, the lighter and/or smaller the curved display device 100. Furthermore, the narrower the width of the bezel 180a, the more the immersive experience with respect to the content displayed by the display device 100. Moreover, as the width of the bezel 180a gets narrower corresponding to the human retina, distortion of content displayed by the display device 100 may decrease. In addition, as the width of the bezel 180a of the top chassis 180 gets narrower, the display device 100 may present a bigger screen relative to the size of the display unit 101 for the user, the screen growing by an extent to which the width of the bezel is narrowed down.

FIG. 3 is a schematic plane view illustrating an example curved display device. Referring to FIG. 3, the curved display device 100 has first, second, and third curvatures. The display panel 170 of the curved display device 100 has the first, second, and third curvatures. The bottom chassis 110 of the curved display device 100 may also have the first, second, and third curvatures. The top chassis 180 of the curved display device 100 may also have the first, second, and third curvatures. The middle frame 160 of the curved display device 100 may also have the first, second, and third curvatures. Furthermore, the other components e.g., 120 to 150 of the curved display device 100 may each also have the first, second, and third curvatures.

Curvatures of the curved display device 100 may be formed by one or more of the bottom chassis 110, middle frame 160, and top chassis 180. Alternatively, curvatures of the curved display device 100 may be formed by a combination of the bottom chassis 110, middle frame 160, and top chassis 180.

In an example of the disclosure, the bottom chassis 110, middle frame 160, and top chassis 180 may be collectively called a "fixed member". For example, the one or more curvatures of the curved display device 100 may be formed by the fixed member. Again, a plurality of curvatures of the curved display device 100 may be formed by the fixed member.

The respective curvatures may be different based on the number of the curvatures divided from the curved display device 100. For example, when the curved display device 100 is divided into three curvatures, a radius of a second curvature c2 of a second area A2 may be 75% or less of a radius of a first curvature c1 of a first area A1 centreed on centre point co. For example, the radius of the second curvature c2 of the second area A2 may be equal to or less than 72% but equal to or higher than 65% of the radius of the first curvature c1. In another example, the radius of the second curvature c2 of the second area A2 may be equal to or less than 68 % but equal to or higher than 62 % of the radius of the first curvature c1.

Relative to the first curvature c₁ of the first area A1 centreed on the centre point co, a radius of a third curvature c₃ of a third area A3 that extends from the second area A2 may be 64% or less of the radius of the first curvature c1. For example, the radius of the third curvature c3 of the third area A3 may be equal to or less than 63 % but equal to or higher than 44% of the radius of the first curvature c1. In another example, the radius of the third curvature c3 of the third area A3 may be equal to or less than 62% but equal to or higher than 40% of the radius of the first curvature c1.

The display panel 170 of the curved display device 100 may have the first area A1 with the first curvature c1, the second area A2 extending from the first area A1 and having the second curvature c2 which is higher than the first curvature c1, and the third area A3 extending from the second area A2 and having the third curvature c3 which is higher than the second curvature C2. For example, the first curvature c1 may be 3000R, the second curvature c2 2000R, and/or third curvature c3 1800R.

The third curvature c3 of the third area A3, a side area, is higher than the first curvature c1 of the first area A1 centreed on the centre point co, i.e., the third area A3 is bent a lot. The third curvature c3 of the third area A3 is higher than the second curvature c2 of the second area A2.

With respect to the centre point co, the curvature (e.g., c3) of a side area (e.g., A3) may be higher than the curvature c1 of the centre area A1. With respect to the centre point co, the curvature (e.g., c2) of a side area (e.g., A2) may be higher than the curvature c1 of the centre area A1. With respect to the centre point co, the curvature (e.g., c3) of a side area (e.g., A3) may be higher than the curvature (e.g., c2) of another side area A2.

The display panel 170 of the curved display device 100 may have the first area A1, the centre area with the first curvature c1, the second area A2 extending from the first area A1 toward either side and having the second curvature c2 which is higher than the first curvature c1, and the third area A3 extending from the second area A2 to be located near either edge and having the third curvature c3 which is higher than the second curvature C2.

A distance l1 from the centre point co to a border e1 between the first and second areas A1 and A2 may, for example, be about 317.5mm. A distance 12 from the border e1 between the first and second areas A1 and A2 to a border e2 between the second and third areas A2 and A3 may, for example, be about 312.3mm. In addition, a distance l3 from the border e2 between the second and third areas A2 and A3 to an end e3 of the third area A3 may, for example, be about 289.2mm. In the bottom chassis 110, a distance from the centre point c0 to the end e3 of the third area A3 may, for example, be about 927.6mm.

In this example, the third curvature c3 of the third area A3, a side area, is higher than the first curvature c1 of the first area A1 centreed on the centre point c0, i.e., the third area A3 is bent a lot. The third curvature c3 of the third area A3 is higher than the second curvature c2 of the second area A2.

In this example, the distance l₁ from the centre point c0 to the border e1 between the first and second areas A1 and A2 is longer than the distance l2 from the border e1 between the first and second areas A1 and A2 to the border e2 between the second and third areas A2 and A3. The distance l1 from the centre point c0 to the border e1 between the first and second areas A1 and A2 may be longer than the distance l3 from the border e2 between the second and third areas A2 and A3 to the end e3 of the third area A3.

In this example, the distance l2 from the border e1 between the first and second areas A1 and A2 to the border e2 between the second and third areas A2 and A3 may be longer than the distance l3 from the border e2 between the second and third areas A2 and A3 to the end e3 of the third area A3.

In this example, the distance l3 across the third area A3 having the highest curvature (e.g., c3 higher than c1 and c2) is shorter than the distance l1 across the first area A1 having the lowest curvature (e.g., c1 less than c2 and c3). The distance l2 across the second area A2 having a high curvature (e.g., c2 higher than c1) may be shorter than the distance l1 across the first area A1 having the lowest curvature c1.

In this example, the distance l3 across the third area having the highest curvature c3 may be shorter than the distance l2 across the second area having the high curvature C2.

In this example, the third area A3 having the third curvature c3 is smaller than the first area A1 having the first curvature c1. The third area A3 having the third curvature c3 is smaller than the second area A2 having the second curvature c2. The second area A2 having the second curvature c2 is smaller than the first area A1 having the first curvature c1.

The aforementioned first, second, and/or third curvature(s) c1, c2, and/or c3 are/is only examples, but are/is not limited thereto. It is to be noted that the first, second, and/or third curvature(s) c1, c2, and/or c3 may vary by one of the size of the bottom chassis 110, the size of the display panel 170, and the aspect ratio of the display panel 170.

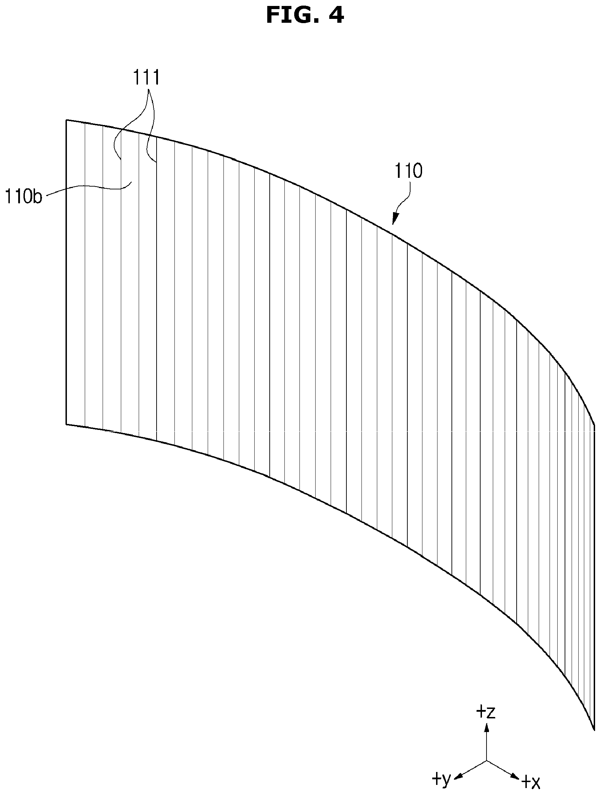

Referring to FIG. 4, the bottom chassis 110 may be formed as a curved plane. Patterns 111 are formed in intaglio e.g., along the z-axis, by being arranged with preset gaps on the rear face 110b of the bottom chassis 110. The bottom chassis 110 may remain as a curved plane with a curvature through plastic deformation by the intaglio patterns 111. The patterns 111 may be formed such that the direction in which the patterns 111 are formed (e.g., along the z-axis) crosses a direction of the curvature (e.g., the direction of the x-axis).

The curved plane of the bottom chassis 110 may be molded by press working. The size of the press working apparatus (not shown) needs to increase as the size of the bottom chassis 110 increases. The curved display device 100 may have various sizes, and the bottom chassis 110 may vary in size based on the size of the display device 100.

If there are various press working apparatuses (not shown) corresponding to various sizes and/or types of the bottom chassis 110, the press working apparatus may not be cost-effective or time-effective.

A manufacturing method in accordance with examples of the disclosure may be applied in forming the curvature of the bottom chassis 110. It will be apparent to those of ordinary skill in this art that the curvature formation on the bottom chassis 110 is only an example, and it may also be applied for the other components (e.g., the middle frame). Furthermore, it is also to be understood that there may be respective methods for manufacturing the bottom chassis 110, the middle frame 160 and/or the top chassis 180.

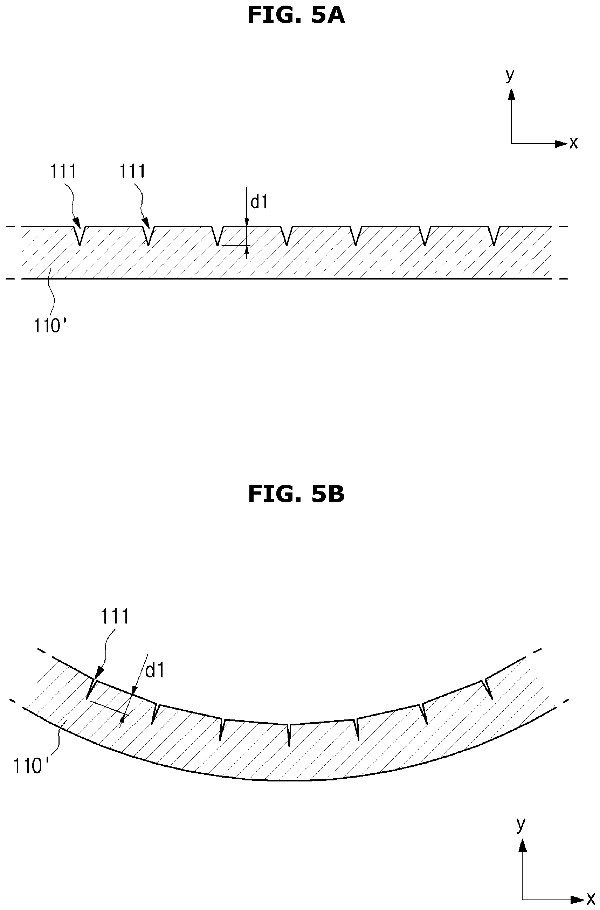

Referring to FIGs. 5A and 5B, patterns 111 may extend in the direction in which the patterns are formed e.g., along the z-axis to form a curvature on the flat bottom chassis 110'. For example, patterns 111 having the same depth d1 may be formed on the rear face 110b of the flat bottom chassis 110'. The patterns 111 with the same depth d1 may be arranged with preset gaps.

The cross-sectional form of one of the patterns 111 may, for example, be a triangle. Alternatively, the cross-sectional form of the pattern 111 may, for example, be a regular triangle, right-angled triangle, or isosceles triangle.

In case of bending one face of the flat bottom chassis 110' with the patterns 111 formed, the flat bottom chassis 110' may have a curvature with the patterns 111. The stronger the force applied for the bending, the higher the curvature of the flat bottom chassis 110' is, e.g., the bottom chassis 110' is more bent.

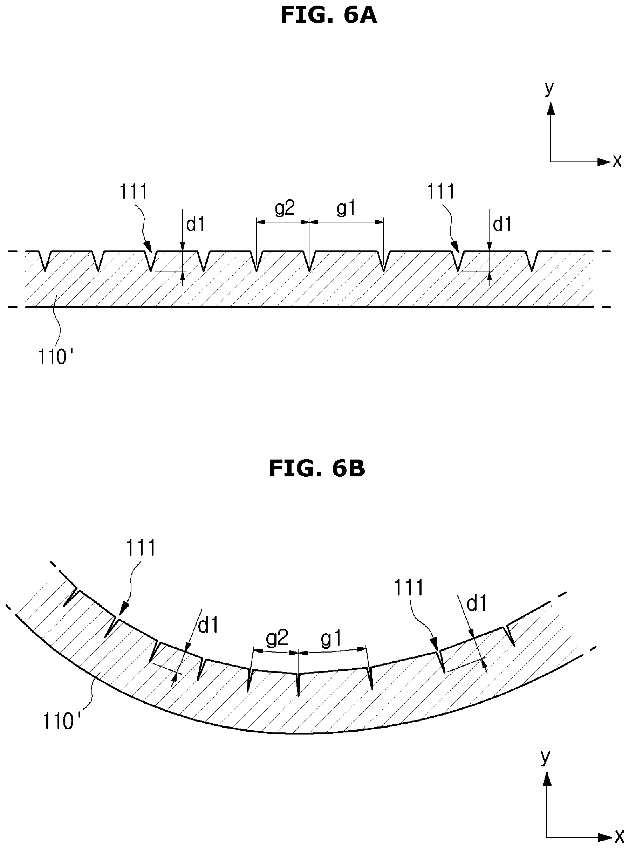

Referring to FIGs. 6A and 6B, patterns 111 with the same depth d1 may extend in the direction in which the patterns are formed e.g., along the z-axis to form a curvature on the flat bottom chassis 110'. For example, patterns 111 having the same depth d1 may be formed on the rear face 110b of the flat bottom chassis 110'. The patterns 111with the same depth d1 may each be arranged with a gap set to correspond to the curvature of the patterns 111. The patterns 111 may have different gaps (e.g., g1, g2) to correspond to curvatures A, B, C (not shown) that is bent more than A, and C that is bent more than B. For example, a gap of the pattern 111 corresponding to the curvature C is narrower than a gap of the pattern 111 corresponding to the curvature A. The gap of the pattern 111 corresponding to the curvature C may be narrower than a gap of the pattern 111 corresponding to the curvature B. Moreover, the gap of the pattern 111 corresponding to the curvature B may be narrower than the gap of the pattern 111 corresponding to the curvature A.

In case of bending one face of the flat bottom chassis 110' with the patterns 111 formed with gaps set to correspond to the respective curvatures, the flat bottom chassis 110' may have different curvatures with the patterns 111 with the gaps set to correspond to the curvatures. The stronger the force applied for the bending, the higher the curvature of the patterns 111 formed to have gaps set to correspond to the curvatures, e.g., the bottom chassis 110' are more bent with the patterns 111 formed to have narrow gaps.

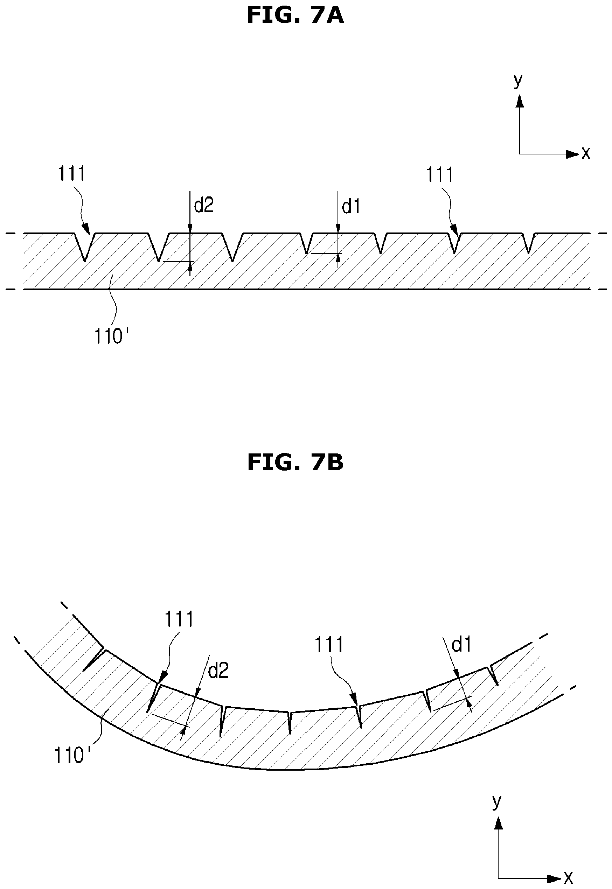

Referring to FIGs. 7A and 7B, the patterns 111 may extend in the direction in which the patterns are formed e.g., along the z-axis to form a curvature on the flat bottom chassis 110'. For example, the patterns 111 having multiple depths e.g., d1, d2 may be formed on the rear face 110b of the flat bottom chassis 110'. The patterns 111 with the multiple depths e.g., d1, d2 may be arranged with preset gaps (e.g., the same gap).

In case of bending one face of the flat bottom chassis 110' with the patterns 111 formed to have multiple depths e.g., d1, d2, the flat bottom chassis 110' may have different curvatures with the patterns 111 of multiple depths d1, d2. The stronger the force applied for the bending, the higher the curvature of the patterns 111 formed with deeper depth d2, e.g., the bottom chassis 110' is more bent in the patterns 111 formed with the deeper depth d2.

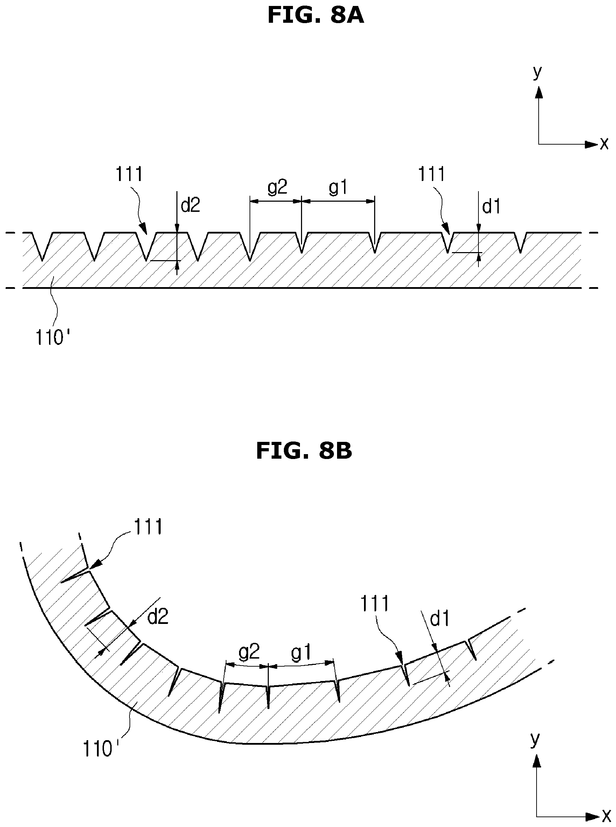

Referring to FIGs. 8A and 8B, patterns 111 having multiple depths, e.g., d1, d2, d3 (not shown) and being arranged with gaps, e.g., g1, g2, g3 (not shown) set to correspond to their curvatures may extend toward a direction in which the patterns are formed, e.g., in the direction of the z-axis to form the curvatures on the flat bottom chassis 110'. For example, the patterns 111 having multiple depths e.g., d1, d2, d3 and being arranged with gaps g1, g2, g3 set to correspond to their curvatures may be formed on the rear face 110b of the flat bottom chassis 110'.

The gaps of the patterns 111 may be different to correspond to curvatures A, B, C (not shown) that is bent more than A, and C that is bent more than B. For example, a gap of the pattern 111 corresponding to the curvature C is narrower than a gap of the patterns 111 corresponding to the curvature A. The gap of the pattern 111 corresponding to the curvature C may be narrower than the gap of the pattern 111 corresponding to the curvature B. Moreover, the gap of the pattern 111 corresponding to the curvature B may be narrower than the gap of the pattern 111 corresponding to the curvature A.

The gaps of the patterns 111 may be different to correspond to their depths d1, d2 that is deeper than d1, and d3 that is deeper than d2. For example, a gap of the pattern 111 corresponding to the depth d3 is narrower than a gap of the pattern 111 corresponding to the depth d1. A gap of the pattern 111 corresponding to the depth d3 may be narrower than a gap of the pattern 111 corresponding to the depth d2. Moreover, a gap of the pattern 111 corresponding to the depth d2 may be narrower than a gap of the pattern 111 corresponding to the depth d1.

In case of bending one face of the flat bottom chassis 110' with the patterns 111 having multiple depths e.g., d1, d2, d3 and being formed with gaps set to correspond to the respective curvature, the flat bottom chassis 110' may have different curvatures with the patterns 111 of gaps set to correspond to their depths and curvatures. As the force applied for the bending gets stronger, the flat bottom chassis 110' having the patterns 111 formed with depths and gaps set to correspond to curvatures may have higher curvature on the patterns 111 with the depth d3 and a narrow gap, e.g., the bottom chassis 110' is more bent with the patterns 111 having the depth d3 and the narrow gap.

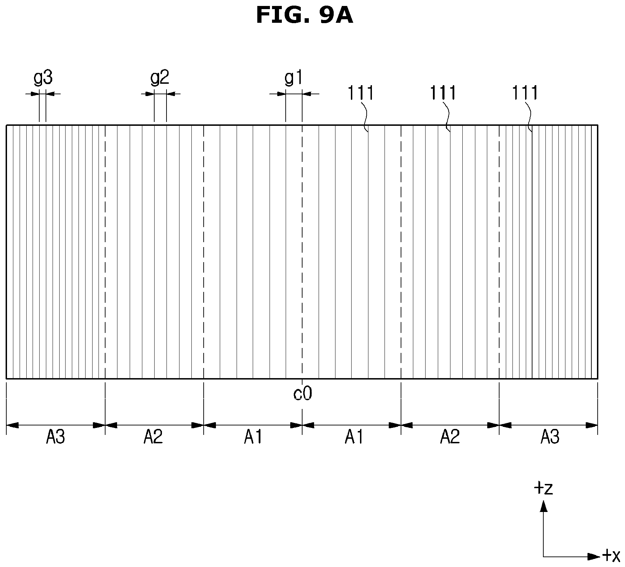

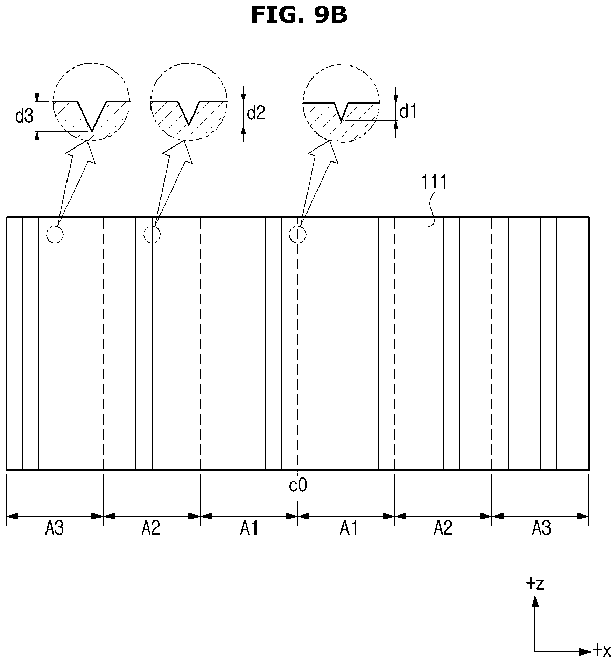

FIGS. 9A and 9B are front views illustrating example patterns of a display device.

Referring to FIGS. 3 and 9A, the bottom chassis 110 has first, second, and third curvatures c1, c2, and c3. A depth of the patterns 111 corresponding to the first curvature c1 may be equal to depths of the patterns 111 corresponding to the second and third curvatures c2 and c3.

In the bottom chassis 110, a gap g1 of the pattern 111 corresponding to the first curvature c1 is greater than a gap g3 of the pattern 111 corresponding to the third curvature c3. A gap g1 of the pattern 111 corresponding to the first curvature c1 may be greater than a gap g2 of the pattern 111 corresponding to the second curvature c2. Moreover, a gap g2 of the pattern 111 corresponding to the second curvature c2 may be greater than a gap g3 of the pattern 111 corresponding to the third curvature c3. In the bottom chassis 110, the number of the patterns 111 corresponding to the first curvature c1 is less than the number of the patterns 111 corresponding to the third curvature c3. The number of the patterns 111 corresponding to the first curvature c1 may be less than the number of the patterns 111 corresponding to the second curvature c2. Moreover, the number of the patterns 111 corresponding to the second curvature c2 may be less than the number of the patterns 111 corresponding to the third curvature c3.

In the bottom chassis 110, a first area A1 corresponding to the first curvature c1 is wider than a third area A3 corresponding to the third curvature c3. The first area A1 corresponding to the first curvature c1 may be wider than the second area A2 corresponding to the second curvature c2. Moreover, the second area A2 corresponding to the second curvature c2 may be wider than the third area A3 corresponding to the third curvature c3.

In case of bending one face of the flat bottom chassis 110' with the patterns 111 formed with different gaps corresponding to multiple curvatures, the bottom chassis 110 may have the multiple curvatures, e.g., c1, c2, c3 with the patterns 111 formed with different gaps.

Referring to FIGS. 3 and 9B, the bottom chassis 110 has first, second, and third curvatures c1, c2, and c3. A gap of the pattern 111 corresponding to the first curvature c1 may be equal to gaps of the patterns 111 corresponding to the second and third curvatures c2 and c3.

In the bottom chassis 110, the depth d1 of the pattern 111 corresponding to the first curvature c1 is shallower than the depth d3 of the pattern 111 corresponding to the third curvature c3. The depth d1 of the pattern 111 corresponding to the first curvature c1 may be shallower than the depth d2 of the pattern 111 corresponding to the second curvature c2. Moreover, the depth d2 of the pattern 111 corresponding to the second curvature c2 may be shallower than the depth d3 of the pattern 111 corresponding to the third curvature c3.

In the bottom chassis 110, a first area A1 corresponding to the first curvature c1 is wider than a third area A3 corresponding to the third curvature c3. The first area A1 corresponding to the first curvature c1 may be wider than the second area A2 corresponding to the second curvature c2. Moreover, the second area A2 corresponding to the second curvature c2 may be wider than the third area A3 corresponding to the third curvature c3.

In case of bending one face of the flat bottom chassis 110' with the patterns 111 formed with different depths corresponding to multiple curvatures, the bottom chassis 110 may have the multiple curvatures, e.g., c1, c2, c3 with the patterns 111 formed with different depths.

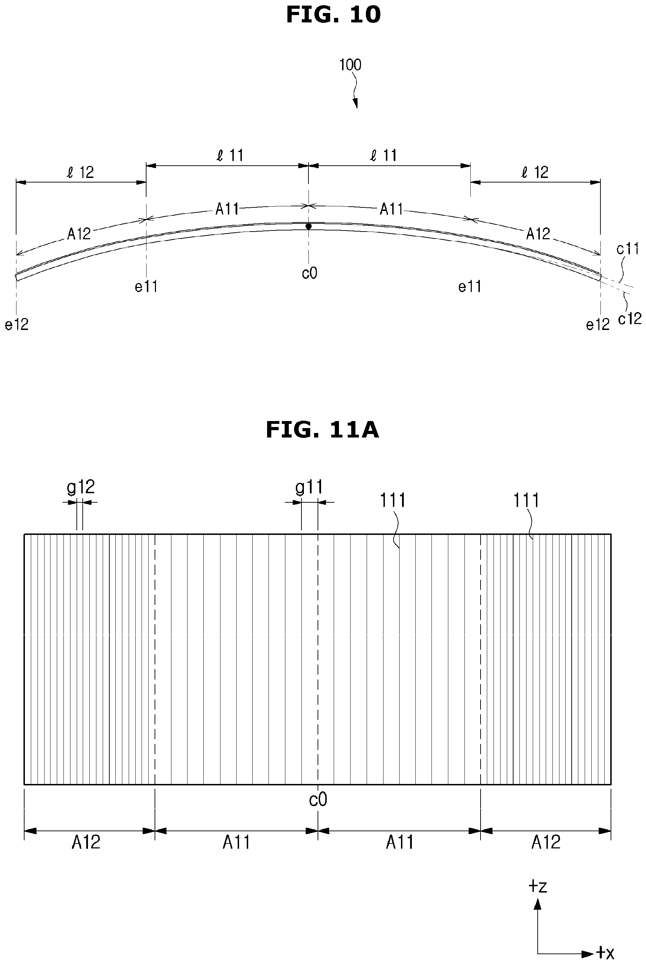

FIG. 10 is a schematic plane view illustrating an example curved display device. Referring to FIG. 10, the curved display device 100 has 11th and 12th curvatures. The display panel 170 of the curved display device 100 may have the 11th and 12th curvatures. The bottom chassis 110 of the curved display device 100 may have the 11th and 12th curvatures. The top chassis 180 of the curved display device 100 may have the 11th and 12th curvatures. Furthermore, the other components e.g., 120 to 160 of the curved display device 100 may each have the 11th and 12th curvatures.

The respective curvatures may be different based on the number of the curvatures divided from the curved display device 100. For example, when the curved display device 100 is divided into two curvatures, a radius of a 12th curvature c12 of a 12th area A12 may be 85% or less of a radius of a 11th curvature c11 of a 11th area A11 centreed on centre point co. For example, the radius of the 12th curvature c12 of the 12th area A12 may be equal to or less than 83% but may be equal to or higher than 65% of the radius of the 11th curvature c11. In another example, the radius of the 12th curvature c12 of the 12th area A12 may be equal to or less than 80% but may be equal to or higher than 49% of the radius of the 11th curvature c11.

The display panel 170 of the curved display device 100 may have the 11th area A11 with the 11th curvature c11, and the 12th area A12 with the 12th curvature c12 that is higher than the 11th curvature c11. For example, the 11th curvature c11 and 12th curvature c12 may be 3000R and 1950R, respectively.

The 12th curvature c12 of the 12th area A12, a side area, is higher than the 11th curvature e11 of the 11th area A11 centreed on the centre point c0, i.e., the 12th area A12 is bent a lot.

With respect to the centre point c0, the curvature (e.g., c12) of a side area (e.g., A12) may be higher than the curvature c11 of the centre area A11.

The display panel 170 of the curved display device 100 may have the 11th area A11 with the 11th curvature c11, the centre area, and the 12th area A12 extending from the 11th area A11 toward either edge to be located on either side and having the 12th curvature c12 that is higher than the 11th curvature c11.

A distance l11 from the centre point c0 to a border e11 between the 11th and 12th areas A11 and A12 may, for example, be about 556.6mm. In addition, a distance l12 from the border e11 between the 11th and 12th areas A11 and A12 to an end e12 of the 12th area A12 may, for example, be about 371.0mm.

The 12th curvature c12 of the 12th area A12, a side area, is higher than the 11th curvature e11 of the 11th area A11 centreed on the centre point c0, i.e., the 12th area A12 is bent a lot.

The distance I11 from the centre point c0 to a border e11 between the 11th and 12th areas A11 and A12 may be longer than the distance l12 from the border e11 between the 11th and 12th areas A11 and A12 to an end e12 of the 12th area A12.

The distance l12 across the 12th area A12 having a high curvature (e.g., c12 higher than c11) may be shorter than the distance l11 across the 11th area A11 having the low curvature c11.

The 12th area A12 having the 12th curvature c12 is smaller than the 11th area A11 having the 11th curvature c11.

The aforementioned 11th and 12th curvatures c11 and c12 are only examples, but are not limited thereto. It is to be noted that the 11th and 12th curvatures c11 and c12 may vary by one of the size of the bottom chassis 110, the size of the display panel 170, and the aspect ratio of the display panel 170, or the like.

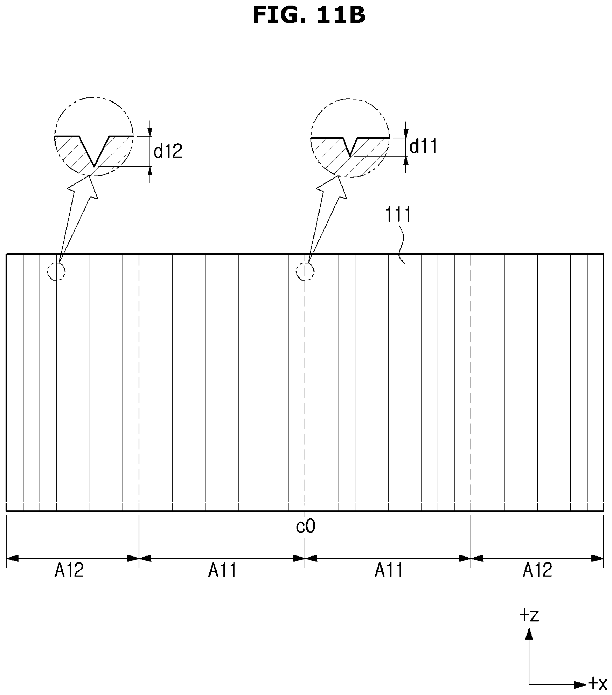

FIGS. 11A and 11B are front views illustrating example patterns of a curved display device.

Referring to FIGS. 10 and 11A, the bottom chassis 110 has the 11th and 12th curvatures c11 and c12. The depth of the pattern 111 corresponding to the 11th curvature c11 may be equal to the depth of the pattern 111 corresponding to the 12th curvature c12.

In the bottom chassis 110, a gap g11 of the patterns 11 corresponding to the 11th curvature c11 is greater than a gap g12 of the pattern 111 corresponding to the 12th curvature c12.
In the bottom chassis 110, the number of the patterns 111 corresponding to the 11th curvature c1 is less than the number of the patterns 111 corresponding to the 12th curvature c12.

In the bottom chassis 110, the 11th area A11 corresponding to the 11th curvature c11 is wider than the 12th area A12 corresponding to the 12th curvature c12.

In case of bending one face of the flat bottom chassis 110' with the patterns 111 formed with different gaps corresponding to multiple curvatures, the bottom chassis 110 may have the multiple curvatures, e.g., c11, c12 with the patterns 111 formed with the different gaps.

Referring to FIGS. 10 and 11B, the bottom chassis 110 has the 11th and 12th curvatures c11 and c12. A gap of the pattern 111 corresponding to the 11th curvature c11 may be equal to the gap of the pattern 111 corresponding to the 12th curvature c12.

In the bottom chassis 110, the depth d11 of the pattern 111 corresponding to the 11th curvature c11 is shallower than the depth d12 of the pattern 111 corresponding to the 12th curvature c12.

In the bottom chassis 110, the 11th area A11 corresponding to the 11th curvature c11 is wider than the 12th area A12 corresponding to the 12th curvature c12.

In case of bending one face of the flat bottom chassis 110' with the patterns 111 formed with different depths e.g., d11, d12, the bottom chassis 110 may have multiple curvatures, e.g., c11, c12 with the patterns 111 formed with the different depths.

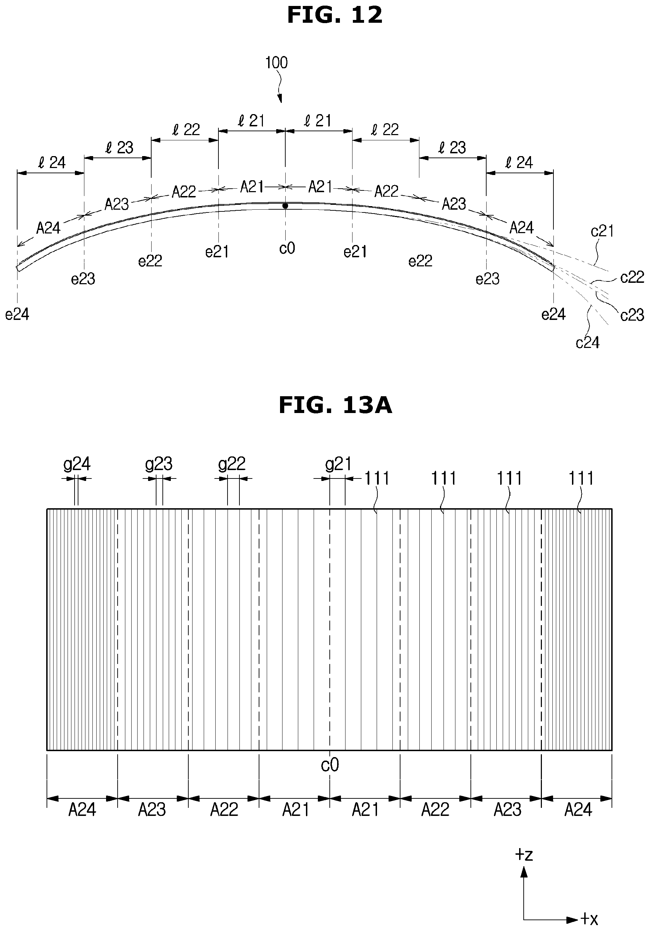

FIG. 12 is a schematic plane view illustrating an example curved display device.

Referring to FIG. 12, the curved display device 100 has 21st, 22nd, 23rd, and 24th curvatures c21, c22, c23, and c24. The display panel 170 of the curved display device 170 may have the 21st, 22nd, 23rd, and 24th curvatures c21, c22, c23, and c24. The bottom chassis 110 of the curved display device 170 may have the 21st, 22nd, 23rd, and 24th curvatures c21, c22, c23, and c24. The top chassis 180 of the curved display device 170 may have the 21st, 22nd, 23rd, and 24th curvatures c21, c22, c23, and c24. Furthermore, the other components e.g., 120 to 160 of the curved display device 100 may have the 21st, 22nd, 23rd, and 24th curvatures c21, c22, c23, and c24.

The respective curvatures may be different based on the number of the curvatures divided from the curved display device 100. For example, when the curved display device 100 is divided into four curvatures, a radius of the 22nd curvature c22 of a 22nd area A22 may be 86 % or less of a radius of the 21st curvature c21 of a 21st area A21 centreed on centre point co. For example, the radius of the 22nd curvature c22 of the 22nd area A22 may be equal to or less than 85 % but may be equal to or higher than 72 % of the radius of the 21st curvature c21. In another example, the radius of the 22nd curvature c22 of the 22nd area A22 may be equal to or less than 81 % but may be equal to or higher than 68 % of the radius of the 21st curvature c21.

Relative to the 21st curvature c21 of the 21st area A21 centreed on the centre point co, a radius of the 23rd curvature c23 of a 23rd area A23 that extends from the 22nd area A22 may be 71 % or less of the radius of the 21st curvature c21. For example, the radius of the 23rd curvature c23 of the 23rd area A23 may be equal to or less than 69 % but may be equal to or higher than 60 % of the radius of the 21st curvature c21. In another example, the radius of the 23rd curvature c23 of the 23rd area A23 may be equal to or less than 68% but may be equal to or higher than 55 % of the radius of the 21st curvature c21.

Relative to the 21st curvature c21 of the 21st area A21 centreed on the centre point co, a radius of the 24th curvature c24 of a 24th area A24 that extends from the 22nd and 23rd areas A22 and A23 may be 65 % or less of the radius of the 21st curvature c21. For example, the radius of the 24th curvature c24 of the 24th area A24 may be equal to or less than 64 % but may be equal to or higher than 54 % of the radius of the 21st curvature c21. In another example, the radius of the 24th curvature c24 of the 24th area A24 may be equal to or less than 62% but may be equal to or higher than 45 % of the radius of the 21st curvature c21.

The display panel 170 of the curved display device 100 may have the 21st area A21 with the 21st curvature c21, the 22nd area A22 extending from the 21st area A21 and having the curvature c22 higher than the 21st curvature c21, the 23rd area A23 extending from the 22nd area A22 and having the curvature C23 higher than the 22nd curvature c22, and the 24th area A24 extending from the 23rd area A23 and having the curvature c24 higher than the 23nd curvature c23. For example, the 21st, 22nd, 23rd, and/or 24th curvatures may be 3000R, 2400R, 1950R, and/or 1650R, respectively.

The 24th curvature c24 of the 24th area A24, a side area, is higher than the 21st curvature c21 of the 21st area A21 centreed on the centre point co, i.e., the 24th area A24 is bent a lot. The 24th curvature c24 of the 24th area A24 is higher than the 22nd curvature c22 of the 22nd area A22. Furthermore, the 24th curvature c24 of the 24th area A24 is higher than the 23rd curvature c23 of the 23rd area A23.

With respect to the centre point co, the curvature (e.g., c24) of the side area (e.g., A24) may be higher than the curvature c21 of the centre area A21. With respect to the centre point co, the curvature (e.g., c23) of the side area (e.g., A23) may be higher than the curvature c21 of the centre area A21. With respect to the centre point co, the curvature (e.g., c22) of the side area (e.g., A22) may be higher than the curvature c21 of the centre area A21.

The display panel 170 of the curved display device 100 may have the 21st area A21, the centre area, with the 21st curvature c21, the 22nd area A22 extending from the 21st area A21 and having the 22nd curvature c22 higher than the 21st curvature c21, the 23rd area A23 extending from the 22nd area A22 and having the 23rd curvature C23 higher than the 22nd curvature C22, and the 24th area A24 extending from the 23rd area A23 to be located on either side and having the 24th curvature c24 higher than the 23nd curvature c23.

A distance l21 from the centre point co to a border e21 between the 21st and 22nd areas A21 and A22 may, for example, be about 245.8mm. A distance l22 from the border e21 between the 21st and 22nd areas A21 and A22 to a border e22 between the 22nd and 23rd areas A22 and A23 may, for example, be about 234.7mm. A distance l23 from the border e22 between the 22nd and 23rd areas A22 and A23 to a border e23 between the 23rd and 24th areas A23 and A24 may, for example, be about 230.0mm. In addition, a distance l24 from the border e23 between the 23rd and 24th areas A23 and A24 to an end e24 of the 24th area A24 may, for example, be about 217.1mm. In the bottom chassis 110, a distance from the centre point co to the end e24 of the 24th area A24 may, for example, be about 927.6mm.

The 24th curvature c24 of the 24th area A24, a side area, is higher than the 21st curvature c21 of the 21st area A21 centreed on the centre point co, i.e., the 24th area A24 is bent a lot. Furthermore, the 24th curvature c24 of the 24th area A24 is higher than the 23rd curvature c23 of the 23rd area A23. The 24th curvature c24 of the 24th area A24, the side area is higher than the 22nd curvature c22 of the 22nd area A22.

The distance l21 from the centre point co to the border e21 between the 21st and 22nd areas A21 and A22 is longer than the distance l22 from the border e21 between the 21st and 22nd areas A21 and A22 to the border e22 between the 22nd and 23rd areas A22 and A23. The distance l21 from the centre point co to the border e21 between the 21st and 22nd areas A21 and A22 may be longer than the distance l23 from the border e22 between the 22nd and 23rd areas A22 and A23 to the border e23 between the 23rd and 24th areas A23 and A24. In addition, the distance l21 may be longer than the distance l24 from the border e23 between the 23rd and 24th areas A23 and A24 to an end e24 of the 24th area A24.

The distance l24 across the 24th area A24 having the highest curvature (e.g., c24 higher than c21, c22, and c23) is shorter than the length l21 across the 21st area A21 having the lowest curvature (e.g., c21 less than c22, c23 and c24). The distance l22 across the 22nd area A22 having a high curvature (e.g., c22 higher than c21) may be shorter than the distance l21 across the 21st area A21 having the lowest curvature c21.

The distance l24 across the 24th area having the highest curvature c24 may be shorter than the distance l23 across the 23rd area having the curvature c23.

The 24th area A24 having the 24th curvature c24 is smaller than the 21st area A21 having the 21st curvature c21. The 24th area A24 having the 24th curvature c24 is smaller than the 22nd area A22 having the 22nd curvature c22. Furthermore, the 24th area A24 having the 24th curvature c24 is smaller than the 23rd area A23 having the 23rd curvature c23.

The 23rd area A23 having the 23rd curvature c23 is smaller than the 21st area A21 having the 21st curvature c21. The 23rd area A23 having the 23rd curvature c23 is smaller than the 22nd area A22 having the 22nd curvature c22.

The 22nd area A22 having the 22nd curvature c22 is smaller than the 21st area A21 having the 21st curvature c21.

The aforementioned 21t, 22nd, 23rd, and/or 24th curvature(s) c21, c22, c23 and/or c24 are/is only examples, but are/is not limited thereto. It is to be noted that the 21t, 22nd, 23rd, and/or 24th curvature(s) c21, c22, c23 and/or c24 may vary by one of the size of the bottom chassis 110, the size of the display panel 170, and the aspect ratio of the display panel 170.

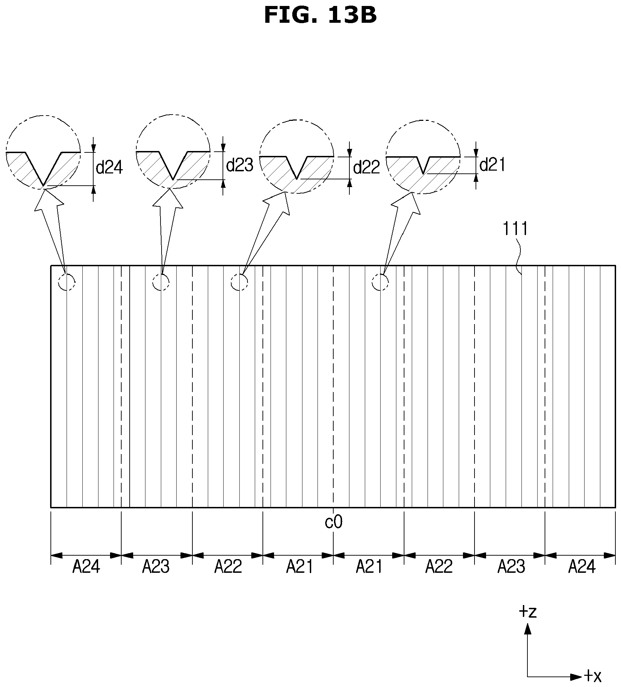

FIGS. 13A and 13B are front views illustrating example patterns of a display device.

Referring to FIGS. 12 and 13A, the bottom chassis 110 has 21st, 22nd, 23rd, and 24th curvatures c21, c22, c23, and c24. A depth of the patterns 111 corresponding to the 21st curvature c21 may be equal to depths of the patterns 111 corresponding to the 22nd, 23rd, and 24th curvatures c22, c23, and c24.

In the bottom chassis 110, a gap g21 of the pattern 111 corresponding to the 21st curvature c21 is greater than a gap g24 of the pattern 111 corresponding to the 24th curvature c24. A gap g21 of the pattern 111 corresponding to the 21st curvature c21 may be greater than a gap g23 of the pattern 111 corresponding to the 23rd curvature c23. Moreover, the gap g21 of the pattern 111 corresponding to the 21st curvature c21 may be greater than a gap g22 of the pattern 111 corresponding to the22nd curvature c22.

In the bottom chassis 110, the gap g22 of the pattern 111 corresponding to the 22nd curvature c22 is greater than the gap g24 of the pattern 111 corresponding to the 24th curvature c24. The gap g22 of the pattern 111 corresponding to the 22nd curvature c22 may be greater than the gap g23 of the pattern 111 corresponding to the 23rd curvature c23.

In the bottom chassis 110, the gap g23 of the pattern 111 corresponding to the 23rd curvature c23 may be greater than the gap g24 of the pattern 111 corresponding to the 24th curvature c24.

In the bottom chassis 110, the number of the patterns 111 corresponding to the 21st curvature c21 is less than the number of the patterns 111 corresponding to the 24th curvature c24. The number of the patterns 111 corresponding to the 21st curvature c21 may be less than the number of the patterns 111 corresponding to the 23rd curvature c23. The number of the patterns 111 corresponding to the 21st curvature c21 may be less than the number of the patterns 111 corresponding to the 2nd curvature c22. In the bottom chassis 110, the number of the patterns 111 corresponding to the 22nd curvature c22 is less than the number of the patterns 111 corresponding to the 24th curvature c24. The number of the patterns 111 corresponding to the 22nd curvature c22 may be less than the number of the patterns 111 corresponding to the 23rd curvature c23.

In the bottom chassis 110, the number of the patterns 111 corresponding to the 23rd curvature c23 may be less than the number of the patterns 111 corresponding to the 24th curvature c24.

In the bottom chassis 110, a 21st area A21 corresponding to the 21st curvature c21 is wider than a 24th area A24 corresponding to the 24th curvature c24. The 21st area A21 corresponding to the 21st curvature c21 may be wider than a 23rd area A23 corresponding to the 23rd curvature c23. Furthermore, the 21st area A21 corresponding to the 21st curvature c21 may be wider than a 22nd area A22 corresponding to the 22nd curvature c23.

In the bottom chassis 110, the 22nd area A22 corresponding to the 22nd curvature c22 is wider than the 24th area A24 corresponding to the 24th curvature c24. The 22nd area A22 corresponding to the 22nd curvature c22 may be wider than the 23rd area A23 corresponding to the 23rd curvature c23.

In the bottom chassis 110, the 23rd area A23 corresponding to the 23rd curvature c23 may be wider than the 24th area A24 corresponding to the 24th curvature c24.

In case of bending one face of the flat bottom chassis 110' with the patterns 111 formed with different gaps corresponding to multiple curvatures, e.g., c1, c2, c3, and c4, the bottom chassis 110 may have the multiple curvatures, e.g., c1, c2, c3, and c4 with the patterns 111 formed with the different gaps.

Referring to FIGS. 12 and 13B, the bottom chassis 110 has 21st, 22nd, 23rd, and 24th curvatures c21, c22, c23, and c24. A gap of the pattern 111 corresponding to the 21st curvature c21 may be equal to a gap of the pattern 111 corresponding to the 22nd, 23rd, or 24th curvature c22, c23, or c24.

In the bottom chassis 110, the depth d21 of the pattern 111 corresponding to the 21st curvature c21 is shallower than the depth d24 of the pattern 111 corresponding to the 24th curvature c24. The depth d21 of the pattern 111 corresponding to the 21st curvature c21 may be shallower than the depth d23 of the pattern 111 corresponding to the 23rd curvature c23. The depth d21 of the pattern 111 corresponding to the 21st curvature c21 may be shallower than the depth d22 of the pattern 111 corresponding to the 22nd curvature c22.

In the bottom chassis 110, the depth d22 of the pattern 111 corresponding to the 22nd curvature c22 is shallower than the depth d24 of the pattern 111 corresponding to the 24th curvature c24. The depth d22 of the pattern 111 corresponding to the 22nd curvature c22 may be shallower than the depth d23 of the pattern 111 corresponding to the 23rd curvature c23.

In the bottom chassis 110, the depth d23 of the pattern 111 corresponding to the 23rd curvature c23 may be shallower than the depth d24 of the pattern 111 corresponding to the 24th curvature c24.

In FIG. 13B, the 21st, 22nd, 23rd, and 24th areas A21, A22, A23, and A24 corresponding to the 21st, 22nd, 23rd, and 24th curvatures c21, c22, c23, and c24, respectively, are substantially equal to those in FIG. 13B, so the description of them will be omitted herein.

In case of bending one face of the flat bottom chassis 110' with the patterns 111 formed with different depths e.g., d21, d22, d23, and d24, the bottom chassis 110 may have multiple curvatures, e.g., c21, c22, c23, and c24 with the patterns 111 formed with the different depths.

It should be readily understood that the display panel 170 of the curved display device 100 may include at least one additional area with additional curvature in addition to the aforementioned areas with the respective curvatures.

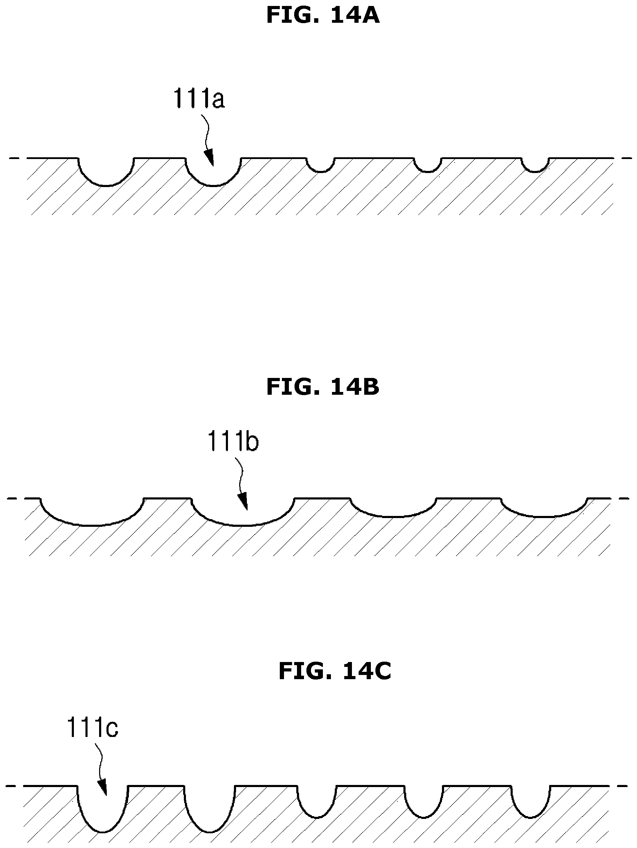

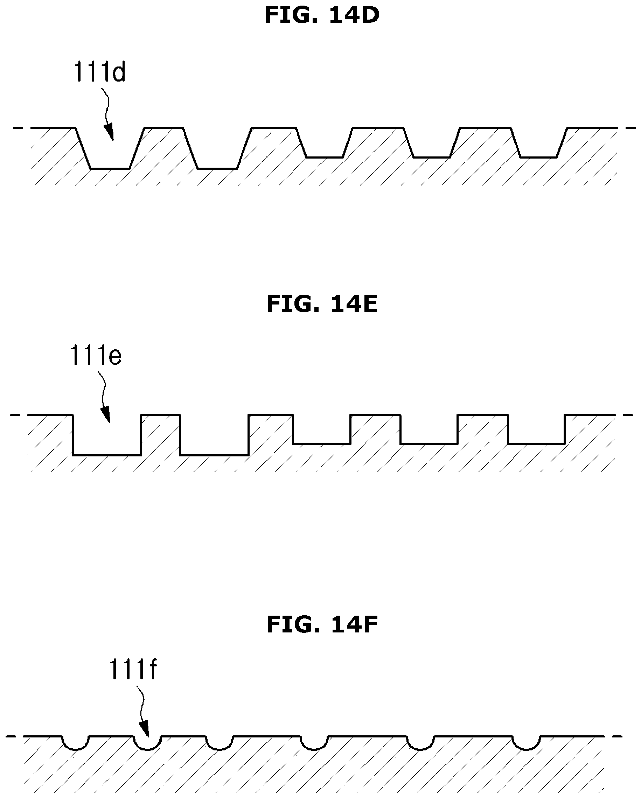

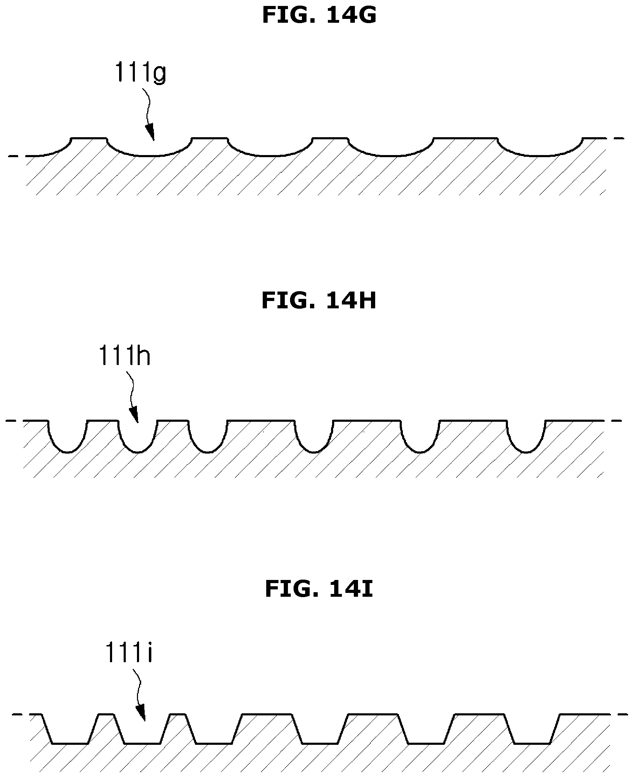

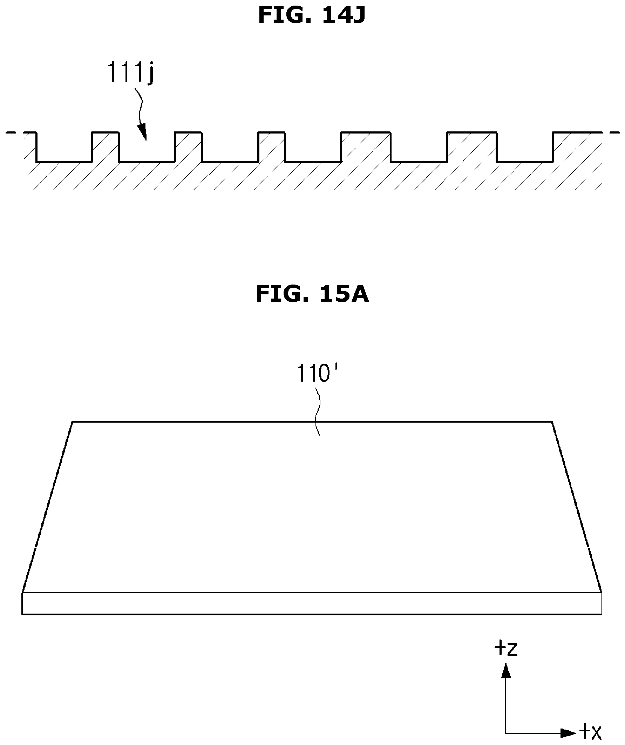

FIGs. 14A-14J are cross-sectional views illustrating example patterns of a curved display device.

Referring to FIGs. 14A-14J, the patterns 111 may have one of various cross-sectional forms, including equidistant semicircles 111a, equidistant ellipses 111b whose width is longer than the depth, equidistant ellipses 111c whose depth is longer than the width, equidistant trapezoids 111d, and/or equidistant rectangles me. Alternatively, the patterns 111 may have one of various cross-sectional forms, including non-equidistant semicircles 111f, non-equidistant ellipses 111g whose width is longer than the depth, non-equidistant ellipses 111h whose depth is longer than the width, non-equidistant trapezoids 111i, and/or non-equidistant rectangles 111j.

Curvatures may be different depending on the different depths and gaps of the patterns in the cross-sectional forms 111a to 111j

The aforementioned cross-sectional forms 111a to 111j of the patterns 111 are only examples, but are not limited thereto.

The patterns 111 may also have multiple cross-sectional forms (not shown). For example, the patterns 111 may have the cross-sectional forms including triangles and semicircles 111a. The aforementioned multiple cross-sectional forms are only examples, but are not limited thereto. For example, a combination of the cross-sectional forms 111a to 111j of the patterns may be implemented.

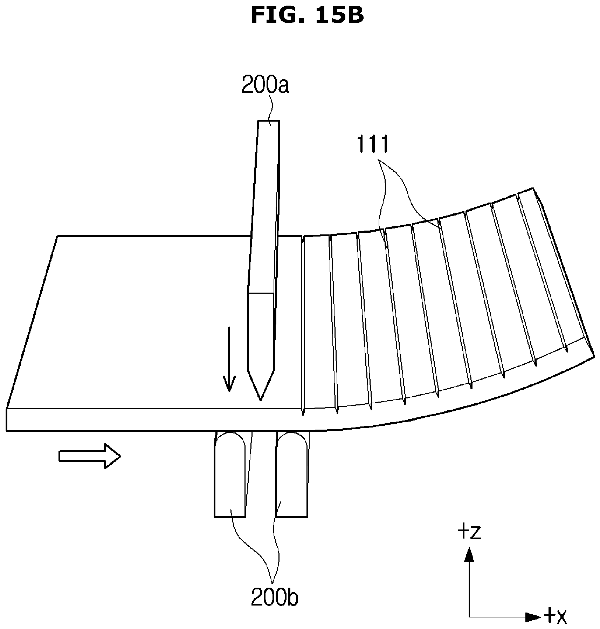

FIGs. 15A and 15B illustrate an example process of manufacturing a bottom chassis of a curved display device.

Referring to FIGs. 15A and 15B, patterns 111 are formed on the flat bottom chassis 110'. A punch 200a may be located on the flat bottom chassis 110' and a punch die 200b corresponding to the punch 200a may be located below the flat bottom chassis 110'. One face e.g., 110b of the flat bottom chassis 110' may be punching-machined by a machining tool (not shown), and the other face e.g., 110a of the flat bottom chassis 110' may be supported by the punch die 200b.

While the flat bottom chassis 110' is shifted along the x-axis, patterns are formed on one face e.g., 110b of the flat bottom chassis 110' by means of the punch 200a of the machining tool (e.g., pressing it in the direction of the z-axis.) Moreover, while the flat bottom chassis 110' is shifted along the x-axis, patterns 111 are formed on the flat bottom chassis 110' using the punch 200a of the machining tool, thereby bending the flat bottom chassis 110'.

In case of forming equidistant patterns 111, the punching speed and the speed at which the flat bottom chassis 110' is shifted along the x-axis may be the same. In another case of forming non-equidistant patterns 111, the punching speed and the speed at which the flat bottom chassis 110' is shifted along the x-axis may be different. For example, the speed at which the flat bottom chassis 110' is shifted may be faster than the punching speed.

In case of forming patterns with different depths, the punching speed and the speed at which the flat bottom chassis 110' is shifted along the x-axis may be different. For example, the punching speed may be faster than the speed at which the flat bottom chassis 110' is shifted, or the pressure may be differently applied for punching.

By varying the punching speed (or the punching pressure) and the speed at which the flat bottom chassis 110' is shifted along the x-axis, patterns corresponding to multiple curvatures may be formed on the flat bottom chassis 110.

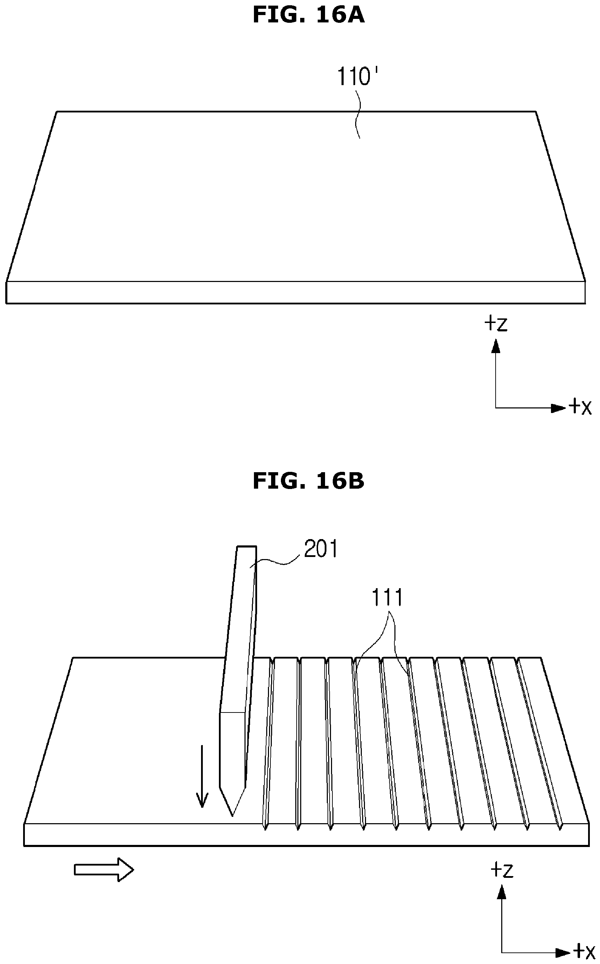

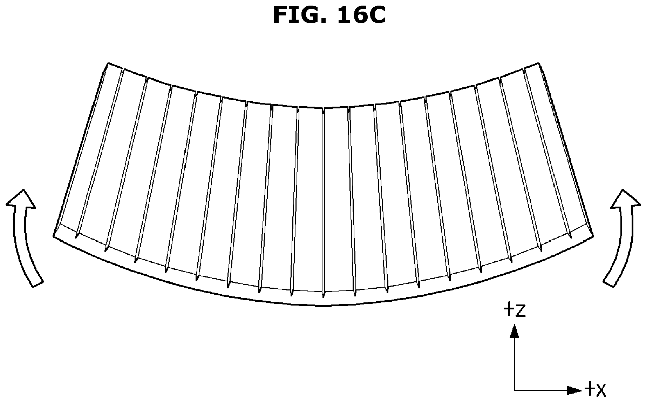

FIGs. 16A-16C illustrate an example process of manufacturing a bottom chassis of a curved display device.

Referring to FIGs. 16A-16C, patterns 111 are formed on the flat bottom chassis 110'. A punch 200a may be located on the flat bottom chassis 110' and a workbench (not shown) may be located below the flat bottom chassis 110'. One face e.g., 110b of the flat bottom chassis 110' may be punching-machined by a machining tool (not shown), and the other face e.g., 110a of the flat bottom chassis 110' may be supported by the workbench. The patterns 111 may be formed on one face of the flat bottom chassis 110', and a curvature may be formed in the direction in which one face of the flat bottom chassis 110' with the patterns 111 formed thereon is bent through plastic deformation.

According to examples of the disclosure, a curved display device may be provided to reduce edge distortion of scaled contents using a display panel having multiple curvatures.

A curved display device may also be provided to reduce edge distortion of scaled contents using a display panel with viewing distances varying by multiple curvatures.

A curved display device may also be provided to improve an immersive experience of the user using a display panel that reduces edge distortions of contents scaled to correspond to multiple curvatures.

A curved display device may also be provided to improve a side viewing angle using a display panel that reduces edge distortions of contents scaled to correspond to multiple curvatures.

However, examples of the disclosure are not limited thereto, and there may be a curved display device provided to reduce edge distortions of scaled contents using a display panel having first, second, and third curvatures.

Several examples have been described, but it will be understood that various modifications can be made without departing the scope of the invention as defined by the claims.

## Claims

1. A curved display device comprising:
a direct type backlight unit (120,130,145,150);
a display panel (170) arranged over the backlight unit (120,130,145,150), the display panel (170) having a centre area and a first side area (A1) extending from each side of the centre area;
wherein a curvature of the first side area (A1) of the display panel (170) is greater than a curvature of the centre area of the display panel (170); and
a rear chassis (110) for accommodating the backlight unit (120,130,145,150) having a rear face (110b) towards the display panel (170), wherein the plurality of curvatures of the display panel (170) correspond to a plurality of curvatures of the rear chassis, **characterised in that** the rear face (110b) has patterns (111) formed therein in order to form the plurality of curvatures of the rear chassis (110), and the patterns (111) comprise preset gaps having a depth and a width in the rear face (110b) of the rear chassis (110).

2. The curved display device of claim 1, wherein a curvature of the centre area is a first curvature, a curvature of the first side area is a second curvature (c2), the display panel (170) having a second side area extending from the first side area with a third curvature (c3) that is greater than the second curvature (c2).

3. The curved display device of claim 2, wherein the display panel (170) has a third side area extending from the second side area, the third side area having a fourth curvature (c4) that is greater than the third curvature (c3).

4. The curved display device of any one of the preceding claims, further comprising a front chassis (180), wherein the plurality of curvatures of the display panel (170) correspond to a plurality of curvatures of the front chassis (180).

5. The curved display device of any one of the preceding claims, further comprising a middle frame (160) configured to support the display panel (170),
wherein the plurality of curvatures of the display panel (170) correspond to a plurality of curvatures of the middle frame (160).

6. The curved display device of any one of the preceding claims, wherein curvatures of side areas of the display panel (170) are symmetric with respect to the centre area of the display panel (170).

7. The curved display device of any one of the preceding claims, wherein the centre area is larger than the first side area.

8. The curved display device of any one of the preceding claims, wherein the patterns (111) formed on the rear face (110b) of the rear chassis (110) are formed in intaglio patterns.

9. The curved display device of claim 8, wherein the rear face (110b) of the rear chassis (110) has one of equidistant intaglio patterns and non-equidistant intaglio patterns formed therein.

10. The curved display device of claim 8 or 9, wherein a gap of an intaglio pattern formed in a side area of the rear chassis (110) is narrower than a gap of an intaglio pattern formed in a centre area (A1) of the rear chassis (110).

11. The curved display device of claim 8, wherein the rear face (110b) of the rear chassis (110) has intaglio patterns with the same depth and intaglio patterns with different depths formed therein.

12. The curved display device of any one of the preceding claims, wherein the display panel (170) has an aspect ratio of 21:9.

13. The curved display device of any one of the preceding claims, wherein the display panel (170) is arranged to display content with a 16:9 aspect ratio in a scaled 21:9 aspect ratio.

14. The curved display device of any one of the preceding claims, wherein side areas (A3,A12,A24) located on the outermost sides of the display panel (170) have the highest curvature (c3,c12,c24).

## Patentansprüche

1. Gekrümmte Anzeigevorrichtung, die Folgendes aufweist:
eine Hintergrundbeleuchtungseinheit des direkten Typs (120,130,145,150);
eine Anzeigetafel (170), die über der Hintergrundbeleuchtungseinheit (120,130,145,150) angeordnet ist, wobei die Anzeigetafel (170) einen mittleren Bereich und einen sich von jeder Seite des mittleren Bereichs erstreckenden ersten Seitenbereich (A1) hat;
wobei eine Krümmung des ersten Seitenbereichs (A1) der Anzeigetafel (170) größer als eine Krümmung des mittleren Bereichs der Anzeigetafel (170) ist; und
ein hinteres Chassis (110) zur Aufnahme der Hintergrundbeleuchtungseinheit (120,130,145,150) mit einer Rückseite (110b) zur Anzeigetafel (170) hin, wobei die mehreren Krümmungen der Anzeigetafel (170) mehreren Krümmungen des hinteren Chassis entsprechen, **dadurch gekennzeichnet, dass** die Rückseite (110b) in ihr ausgebildete Muster (111) hat, um die mehreren Krümmungen des hinteren Chassis (110) zu bilden, und die Muster (111) vorgegebene Spalten mit einer Tiefe und einer Breite in der Rückseite (110b) des hinteren Chassis (110) aufweisen.

2. Gekrümmte Anzeigevorrichtung nach Anspruch 1, wobei eine Krümmung des mittleren Bereichs eine erste Krümmung ist, eine Krümmung des ersten Seitenbereichs eine zweite Krümmung (c2) ist, die Anzeigetafel (170) einen sich vom ersten Seitenbereich erstreckenden zweiten Seitenbereich mit einer dritten Krümmung (c3) hat, die größer als die zweite Krümmung (c2) ist.

3. Gekrümmte Anzeigevorrichtung nach Anspruch 2, wobei die Anzeigetafel (170) einen sich von dem zweiten Seitenbereich erstreckenden dritten Seitenbereich hat, wobei der dritte Seitenbereich eine vierte Krümmung (c4) hat, die größer als die dritte Krümmung (c3) ist.

4. Gekrümmte Anzeigevorrichtung nach einem der vorhergehenden Ansprüche, die ferner ein vorderes Chassis (180) aufweist, wobei die mehreren Krümmungen der Anzeigetafel (170) mehreren Krümmungen des vorderen Chassis (180) entsprechen.

5. Gekrümmte Anzeigevorrichtung nach einem der vorhergehenden Ansprüche, die ferner einen mittleren Rahmen (160) aufweist, der zum Tragen der Anzeigetafel (170) gestaltet ist,
wobei die mehreren Krümmungen der Anzeigetafel (170) mehreren Krümmungen des mittleren Rahmens (160) entsprechen.

6. Gekrümmte Anzeigevorrichtung nach einem der vorhergehenden Ansprüche, wobei die Krümmungen von Seitenbereichen der Anzeigetafel (170) in Bezug auf den mittleren Bereich der Anzeigetafel (170) symmetrisch sind.

7. Gekrümmte Anzeigevorrichtung nach einem der vorhergehenden Ansprüche, wobei der mittlere Bereich größer als der erste Seitenbereich ist.

8. Gekrümmte Anzeigevorrichtung nach einem der vorhergehenden Ansprüche, wobei die an der Rückseite (110b) des hinteren Chassis (110) ausgebildeten Muster (111) eingeformte Tiefdruckmuster sind.

9. Gekrümmte Anzeigevorrichtung nach Anspruch 8, wobei in der Rückseite (110b) des hinteren Chassis (110) eines von abstandsgleichen Tiefdruckmustern und nicht abstandsgleichen Tiefdruckmustern eingeformt ist.

10. Gekrümmte Anzeigevorrichtung nach Anspruch 8 oder 9, wobei ein Spalt eines in einem Seitenbereich des hinteren Chassis (110) ausgebildeten Tiefdruckmusters schmäler als ein Spalt eines in einem mittleren Bereich (A1) des hinteren Chassis (110) ausgebildeten Tiefdruckmusters ist.

11. Gekrümmte Anzeigevorrichtung nach Anspruch 8, wobei die Rückseite (110b) des hinteren Chassis (110) darin ausgebildete Tiefdruckmuster mit der gleichen Tiefe und Tiefdruckmuster mit verschiedenen Tiefen hat.

12. Gekrümmte Anzeigevorrichtung nach einem der vorhergehenden Ansprüche, wobei die Anzeigetafel (170) ein Seitenverhältnis von 21:9 hat.

13. Gekrümmte Anzeigevorrichtung nach einem der vorhergehenden Ansprüche, wobei die Anzeigetafel (170) zum Anzeigen von Inhalt mit einem Seitenverhältnis von 16:9 in einem skalierten Seitenverhältnis von 21:9 angeordnet ist.

14. Gekrümmte Anzeigevorrichtung nach einem der vorhergehenden Ansprüche, wobei an den äußersten Seiten der Anzeigetafel (170) befindliche Seitenbereiche (A3,A12,A24) die stärkste Krümmung (c3,c12,c24) haben.

## Revendications

1. Dispositif d'affichage incurvé comprenant :
une unité de rétroéclairage de type direct (120,130,145,150) ;
un panneau d'affichage (170) agencé par-dessus l'unité de rétroéclairage (120,130,145,150), le panneau d'affichage (170) comportant une zone centrale et une première zone latérale (A1) partant de chaque côté de la zone centrale ;
dans lequel une courbure de la première zone latérale (A1) du panneau d'affichage (170) est supérieure à une courbure de la zone centrale du panneau d'affichage (170) ; et
un châssis arrière (110) destiné à héberger l'unité de rétroéclairage (120,130,145,150) ayant une face arrière (110b) vers le panneau d'affichage (170), dans lequel la pluralité de courbures du panneau d'affichage (170) correspond à une pluralité de courbures du châssis arrière, **caractérisé en ce que** dans la face arrière (110b) sont formés des motifs (111) afin de former la pluralité de courbures du châssis arrière (110), et les motifs (111) comprennent des espaces prédéfinis d'une profondeur et d'une largeur dans la face arrière (110b) du châssis arrière (110).

2. Dispositif d'affichage incurvé selon la revendication 1, dans lequel une courbure de la zone centrale est une première courbure, une courbure de la première zone latérale est une deuxième courbure (c2), le panneau d'affichage (170) comportant une deuxième zone latérale partant de la première zone latérale d'une troisième courbure (c3) supérieure à la deuxième courbure (c2).

3. Dispositif d'affichage incurvé selon la revendication 2, dans lequel le panneau d'affichage (170) comporte une troisième zone latérale partant de la deuxième zone latérale, la troisième zone latérale ayant une quatrième courbure (c4) supérieure à la troisième courbure (c3).

4. Dispositif d'affichage incurvé selon l'une quelconque des revendications précédentes, comprenant en outre un châssis avant (180), dans lequel la pluralité de courbures du panneau d'affichage (170) correspond à une pluralité de courbures du châssis avant (180).

5. Dispositif d'affichage incurvé selon l'une quelconque des revendications précédentes, comprenant en outre un cadre intermédiaire (160) configuré pour supporter le panneau d'affichage (170),
dans lequel la pluralité de courbures du panneau d'affichage (170) correspond à une pluralité de courbures du cadre intermédiaire (160).

6. Dispositif d'affichage incurvé selon l'une quelconque des revendications précédentes, dans lequel des courbures de zones latérales du panneau d'affichage (170) sont symétriques par rapport à la zone centrale du panneau d'affichage (170).

7. Dispositif d'affichage incurvé selon l'une quelconque des revendications précédentes, dans lequel la zone centrale est plus grande que la première zone latérale.

8. Dispositif d'affichage incurvé selon l'une quelconque des revendications précédentes, dans lequel les motifs (111) formés sur la face arrière (110b) du châssis arrière (110) sont formés en creux.

9. Dispositif d'affichage incurvé selon la revendication 8, dans lequel dans la face arrière (110b) du châssis arrière (110) est formé l'un de motifs en creux équidistants et de motifs en creux non équidistants.

10. Dispositif d'affichage incurvé selon la revendication 8 ou 9, dans lequel un espace d'un motif en creux formé dans une zone latérale du châssis arrière (110) est plus étroit qu'un espace d'un motif en creux formé dans une zone centrale (A1) du châssis arrière (110).

11. Dispositif d'affichage incurvé selon la revendication 8, dans lequel dans la face arrière (110b) du châssis arrière (110) sont formés des motifs en creux de la même profondeur et des motifs en creux de profondeurs différentes.

12. Dispositif d'affichage incurvé selon l'une quelconque des revendications précédentes, dans lequel le panneau d'affichage (170) a un rapport d'aspect de 21:9.

13. Dispositif d'affichage incurvé selon l'une quelconque des revendications précédentes, dans lequel le panneau d'affichage (170) est agencé pour afficher un contenu d'un rapport d'aspect de 16:9 dans un rapport d'aspect d'une échelle de 21:9.

14. Dispositif d'affichage incurvé selon l'une quelconque des revendications précédentes, dans lequel les zones latérales (A3,A12,A24) situées sur les côtés les plus externes du panneau d'affichage (170) présentent la plus grande courbure (c3,c12,c24).
